# EUROPEAN PATENT APPLICATION

(11) **EP 3 190 601 A1**
(43) Date of publication of application: **12.07.2017**
(21) Application number: 15838992.4
(22) Date of filing: 13.03.2015
(51) Int. Cl.: H01H 33/668

(54) **VACUUM VALVE PRESSURE DIAGNOSTIC DEVICE OR VACUUM VALVE DEVICE**

(30) Priority: 01.09.2014 JP 2014176717
(71) Applicant: Hitachi Industrial Equipment Systems Co., Ltd., Tokyo 101-0022 (JP)
(72) Inventor: SATOU, Kazuhiro, Tokyo 100-8280 (JP); MORITA, Ayumu, Tokyo 100-8280 (JP); URAI, Hajime, Tokyo 100-8280 (JP); TSUCHIYA, Kenji, Tokyo 100-8280 (JP)
(74) Representative: Strehl Schübel-Hopf & Partner
(86) International application number: PCT/JP2015/057405
(87) International publication number: WO 2016/035365

(57) **Abstract**

The objective of the present invention is to provide a vacuum valve pressure diagnostic device allowing for a reduction in size of a vacuum valve, with improved safety and reliability for a switching device equipped with the vacuum valve. In order to achieve the above objective, the present invention provides a pressure diagnostic device which diagnoses the pressure in a vacuum valve that has therein a vacuum container wherein the interior is a vacuum, a plurality of contact points (10, 11) that are disposed inside the vacuum container and can be brought into mutual contact or separated from one another, and a floating potential metal (6) electrically insulated from the contact points (10, 11), said pressure diagnostic device being characterized in that: the pressure diagnostic device comprises an insulator group constituted by connecting at least some of a plurality of insulators (13, 14) in series, and an electric potential meter (15) connected between the plurality of insulators (13, 14); for at least one insulator (13) located on the side close to the floating potential metal (6) within the insulator group, the distance to the floating potential metal (6) is changed to a shorter distance at the time of pressure diagnosis; and the insulator (14) which is different from the at least one insulator (13) located on the side close to the floating potential metal (6) within the insulator group is connected at the time of pressure diagnosis to a potential fixing point.

## Description

### TECHNICAL FIELD

The present invention relates to a vacuum valve pressure diagnostic device or a vacuum valve device.

### BACKGROUND ART

As a prior art related to a vacuum valve pressure diagnostic device, there is JP-AS61-263015 (Patent Literature 1). In this Publication, there is described "a vacuum drop detection device for a vacuum valve featured to include a first detector detecting the ground voltage waveform of the line potential member connected to the vacuum valve, a second detector detecting the ground voltage waveform of the intermediate shield, a determination circuit obtaining the determination signal of the pressure rise of the vacuum valve from the variation amount of the detected waveform of the second detector with respect to the detected waveform of the first detector, and a storage device storing the determination signal of the determination circuit in a device for detecting the pressure rise of the vacuum valve that includes a metal-made intermediate shield so as to be insulated from the line potential member."

### CITATION LIST

### PATENT LITERATURE

Patent Literature 1: JP-A-S61-263015

### SUMMARY OF INVENTION

### TECHNICAL PROBLEM

In Patent Literature 1 described above, a device for detecting the pressure rise of a vacuum valve is described. However, with respect to the configuration of Patent Literature 1, because a voltage-dividing capacitor for detecting the ground voltage waveform of the intermediate shield is constantly connected to the intermediate shield, the potential of the intermediate shield becomes close to the ground potential compared to the case the voltage-dividing capacitor is not connected. In other words, because the potential difference between the main circuit conductor of the vacuum valve and the intermediate shield becomes large, the electric field of each part becomes high, and there is a risk that electric discharge occurs between the main circuit conductor of the vacuum valve and the intermediate shield and erroneous detection occurs as the pressure rise even when the pressure is not abnormal.

The object of the present invention is to provide a vacuum valve pressure diagnostic device or a vacuum valve device with improved reliability.

### SOLUTION TO PROBLEM

In order to achieve the above object, the vacuum valve pressure diagnostic device related to the present invention is a pressure diagnostic device which diagnoses the pressure of a vacuum valve that has therein a vacuum container whose interior is a vacuum, plural contact points that are disposed inside the vacuum container and can be brought into mutual contact or separated from each other, and a floating potential metal electrically insulated from the contact points, said pressure diagnostic device being characterized in that: the pressure diagnostic device includes an insulator group constituted by connecting at least some of plural insulators in series, and a potential measuring instrument connected between the plural insulators; for at least one insulator located on the side close to the floating potential metal within the insulator group, the distance to the floating potential metal is changed at the time of pressure diagnosis; and the insulator which is different from the at least one insulator located on the side close to the floating potential metal within the insulator group is connected to a potential fixed point at the time of pressure diagnosis.

Also, the vacuum valve device related to the present invention is characterized to include the vacuum valve pressure diagnostic device and the vacuum valve.

### ADVANTAGEOUS EFFECTS OF INVENTION

According to the present invention, a vacuum valve pressure diagnostic device or a vacuum valve device with improved reliability can be provided.

### BRIEF DESCRIPTION OF DRAWINGS

[FIG. 1] FIG. 1 is a schematic drawing of Embodiment 1 of the present invention.
[FIG. 2] FIG. 2 is a schematic drawing of Embodiment 2 of the present invention.
[FIG. 3] FIG. 3 is a schematic drawing of Embodiment 3 of the present invention.
[FIG. 4] FIG. 4 is a schematic drawing of Embodiment 4 of the present invention.
[FIG. 5] FIG. 5 is a schematic drawing of Embodiment 5 of the present invention.
[FIG. 6] FIG. 6 is a schematic drawing of Embodiment 6 of the present invention.
[FIG. 7] FIG 7 is a schematic drawing of Embodiment 7 of the present invention.
[FIG. 8] FIG. 8 is a schematic drawing of Embodiment 8 of the present invention.
[FIG. 9] FIG. 9 is a characteristic diagram showing a correlation between the atmospheric pressure and the discharge voltage when the gap length between the electrodes is 5 mm.

### DESCRIPTION OF EMBODIMENTS

Below, embodiments of the vacuum valve pressure diagnostic device or the vacuum valve device of the present invention will be described using the drawings. Also, the followings are consistent embodiments suitable to implementation of the present invention, and do not intend to limit the application object of the present invention.

### EMBODIMENT 1

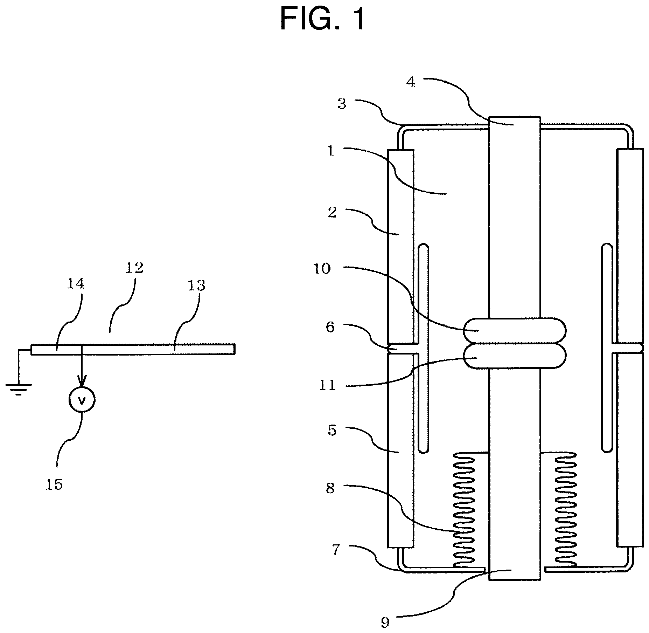

FIG. 1 shows Embodiment 1 of the present invention. With respect to a vacuum valve 1 shown on the right side of FIG. 1, a vacuum container is formed of a fixed side end plate 3 that is joined to one end of a cylindrical insulation material 2 of the fixed side, a fixed side conductor 4 that hermetically penetrates the fixed side end plate 3, a floating potential metal 6 that is joined to the other end of the cylindrical insulation material 2 of the fixed side and one end of a cylindrical insulation material 5 of the movable side, a movable side end plate 7 that is joined to the other end of the cylindrical insulation material 5 of the movable side, bellows 8 with one end being joined to the movable side end plate 7, allowing the movable part to move, and having an accordion shape for retaining vacuum of the interior, and a movable side conductor 9 that hermetically penetrates the bellows 8 and axially drives while retaining a vacuum, and the internal pressure is retained in a vacuum state of approximately 10⁻² Pa or less.

Inside the vacuum container, a fixed side electrode 10 (one of the contact points) connected to an end of the fixed side conductor 4 and a movable side electrode 11 (one of the contact points) connected to an end of the movable side conductor 9 are disposed, and the movable side conductor 9 is connected to an operative insulation rod and an operation tool not shown, the operation tool being joined to a wipe mechanism that applies a contact load to the electrode pair, and is capable of driving in the axial direction. Thus, open and close of the fixed side electrode 10 and the movable side electrode 11 namely the open state and the closed state of the vacuum valve is switched.

Also, a pressure diagnostic device 12 shown on the left side of FIG. 1 is formed of plural insulators having different impedance which are a insulator group formed by connecting an insulator 13 and an insulator 14 in series here, and a potential measuring instrument 15 connected between the insulators. Further, the plural insulators only have to be connected in series at least partially. One end of the insulator 14 and one end of the potential measuring instrument 15 are connected to the potential fixed point, and the voltage occurring between both ends of the insulator 14 can be measured by the potential measuring instrument 15. Although the potential fixed point is the ground potential in the present embodiment, the potential fixed point is not limited to grounding as far as the potential can be determined at the time of diagnosis. Also, the impedance of the insulator 13 of the side close to the floating potential metal 6 is made (significantly) greater than that of the insulator 14 of the side far from the floating potential metal 6. Further, although plural insulators having different impedance are used in the present embodiment, it is not necessarily required to differentiate the impedance. However, by making the impedance of the insulator of the side close to the floating potential metal relative to the potential measuring instrument 15 greater than the impedance of the insulator of the side far from the floating potential metal relative to the potential measuring instrument 15, the voltage applied to the potential measuring instrument 15 can be reduced (for embodiment approximately several volts and the like with respect to the operation voltage of several tens kV), and the configuration of the potential measuring instrument 15 can be made simple.

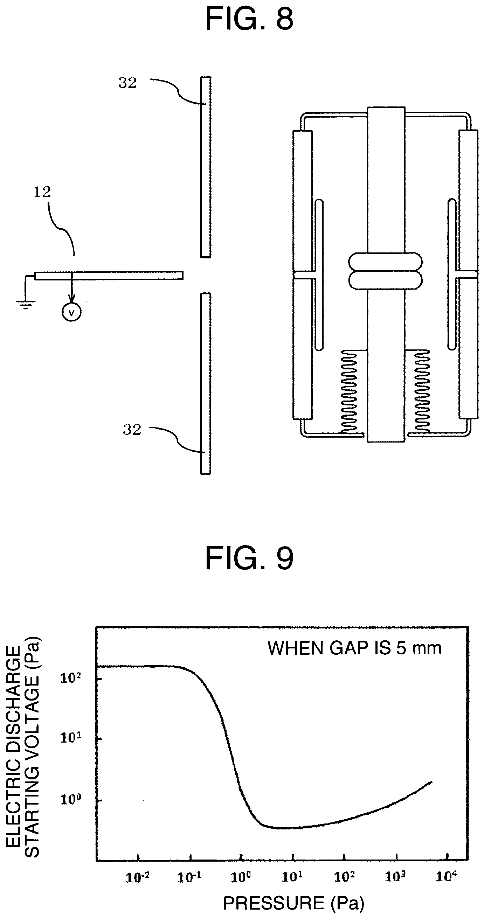

Next, deterioration of the pressure of the vacuum valve 1 namely the case the pressure inside the vacuum container has risen will be described. In general, pressure rise inside the vacuum container occurs mainly by the causes of gas permeation from outside the vacuum container, discharge of gas through the internal member of the vacuum container, a pinhole and the like rarely occurring at the bellows, joining parts and the like, and the insulation performance starts to lower sharply when the pressure becomes approximately 10⁻¹ Pa or more as shown in Paschen's curve of FIG 9.

When pressure rise occurs in the vacuum valve while the switching device mounted with the vacuum valve 1 is in the normal operation state and the insulation performance lowers, electric discharge occurs between the main circuit formed of the fixed side conductor 4, the fixed side electrode 10, the movable side conductor 9, and the movable side electrode 11 and the floating potential metal 6 that is electrically insulated from the main circuit.

Here, although the potential of the floating potential metal 6 at the time of the normal operation when pressure rise does not occur in the vacuum valve 1 is determined generally by the operation voltage, the vacuum valve structure, the layout of the fixed potential member around the vacuum valve, and so on, when electric discharge occurs between the main circuit of the vacuum valve 1 and the floating potential metal 6, the potential of the floating potential metal 6 becomes the potential obtained by adding the discharge pulse onto the potential of the normal operation time. Also, when the pressure further rises, the discharge pulses increased are added, and the potential of the floating potential metal 6 eventually rises to a state close to the operation voltage.

In the present embodiment, in the vacuum valve 1 and the pressure diagnostic device 12 described above, at the time of pressure diagnosis, pressure diagnosis of the vacuum valve is executed by changing the distance between the floating potential metal 6 of the vacuum valve 1 and the insulator 13 of the side closest to the floating potential metal 6 (changing the distance so that the distance becomes shorter compared to that of the time other than the pressure diagnosing time). The vacuum valve pressure diagnostic device executed thus can intentionally drop the potential of the floating potential metal 6 to equal to or less than the potential of the normal operation time. As a result, the potential difference between the main circuit and the floating potential metal 6 becomes large, and the electric field of each part between the main circuit and the floating potential metal 6 becomes high. Because this state becomes an environment easily causing electric discharge between the main circuit and the floating potential metal 6 compared to the state in which the pressure diagnosis is not executed, when pressure rise occurs in the vacuum valve 1, electric discharge can be induced with high sensitivity. When electric discharge occurs, the potential of the floating potential metal 6 becomes the potential added with the discharge pulse onto the potential of the normal operation time, this potential variation can be detected by the voltage value measured by the potential measuring instrument 15 which is connected between the insulator 13 and the insulator 14 of the pressure diagnostic device 12.

According to the vacuum valve pressure diagnostic device described above, because the insulation requirement of the vacuum valve at the normal operation time can be relaxed, the vacuum valve or the switchgear mounted with the vacuum valve can be made compact.

Also, when pressure diagnosis of the vacuum valve is executed while the vacuum valve is in the open state and in a state pressure rise occurs in the vacuum valve 1, because there is a problem of the electric discharge from one main circuit that becomes the electric supply side of the vacuum valve to the other main circuit that becomes the load side, by executing pressure diagnosis of the vacuum valve only when the vacuum valve is in the closed state, the vacuum valve pressure diagnostic device capable of preventing a ground fault accident and having improved safety and reliability can be provided.

According to the present embodiment, at the time of the pressure diagnosis, pressure diagnosis of the vacuum valve is executed by changing the distance between the floating potential metal 6 of the vacuum valve 1 and the insulator 13 located on the side close to the floating potential metal 6. As the vacuum valve pressure diagnostic device, following advantage for embodiment is conceivable. That is to say, because electric discharge can be induced in such a state that electric discharge has not yet occurred at the time of normal use, pressure variation can be grasped before an accident occurs. Accordingly, because the pressure diagnosis accuracy can be improved, improvement of the reliability can be expected.

Further, with respect to the vacuum valve device equipped with the pressure diagnostic device related to the present embodiment, because the pressure diagnosis accuracy is improved, provision of a vacuum valve device with high reliability particularly with respect to vacuum pressure becomes possible. In addition, it is configured that the distance between the floating potential metal 6 of the vacuum valve 1 and the insulator 13 located on the side close to the floating potential metal 6 is changed at the diagnosis time, and, by making the floating potential metal 6 of the vacuum valve 1 and the insulator 13 located on the side close to the floating potential metal 6 apart from each other at the time other than the diagnosis time, deterioration of the insulation property at the time other than the diagnosis time is prevented. Seen in this light also, improvement of the reliability in insulation can be expected.

### EMBODIMENT 2

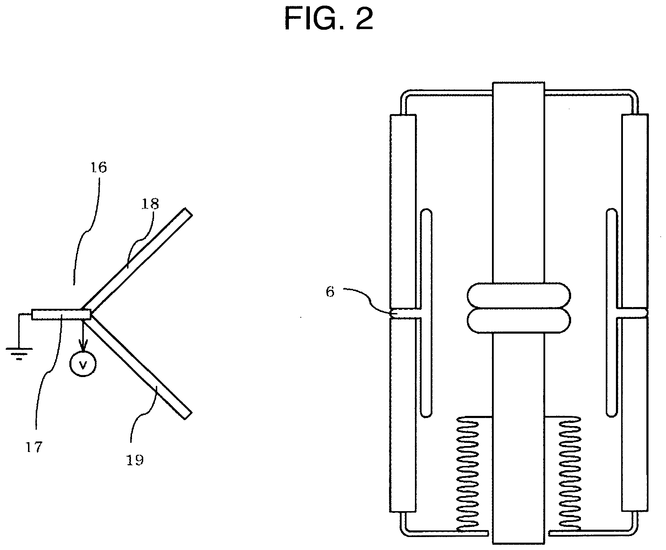

FIG. 2 shows Embodiment 2 of the present invention. Description on portions similar to those of Embodiment 1 will be omitted. In a pressure diagnostic device 16 of the present embodiment, the insulator group is branched on the side close to the floating potential metal, and the insulator on the side close to the floating potential metal 6 is arranged by plural numbers. Also, each insulator close to the floating potential metal 6 is configured that plural insulators having different impedance are connected partially in series. In concrete terms, the pressure diagnostic device is formed of an insulator group and the potential measuring instrument, with the insulator group being formed by connecting an insulator 18 and an insulator 19 having different impedance to one end of an insulator 17, and with the potential measuring instrument being connected between the insulators. In the present embodiment, for the purpose of simple explanation in particular, description is made with an embodiment of a case in which 2 pieces of the insulators on the side close to the floating potential metal 6 namely the insulator 18 and the insulator 19 exist, however, the cases of more than 2 pieces are not to be excluded.

In the present embodiment, pressure diagnosis of the vacuum valve is executed by changing the distance between the floating potential metal 6 of the vacuum valve and at least one of the insulators on the side close to the floating potential metal 6 (the insulator 18 or the insulator 19) at the normal operation time of the vacuum valve 1. In the vacuum valve pressure diagnostic device executed thus also, similarly to Embodiment 1, the potential of the floating potential metal 6 can be dropped intentionally to equal to or less than the potential of the normal operation time. Further, in the present embodiment, by switching the insulator 18 and the insulator 19 having different impedance, the drop width of the potential of the floating potential metal 6 can be changed. As a result, because the electric discharge can be detected with higher sensitivity for embodiment compared to Embodiment 1, provision of the vacuum valve pressure diagnostic device having high reliability also becomes possible.

### EMBODIMENT 3

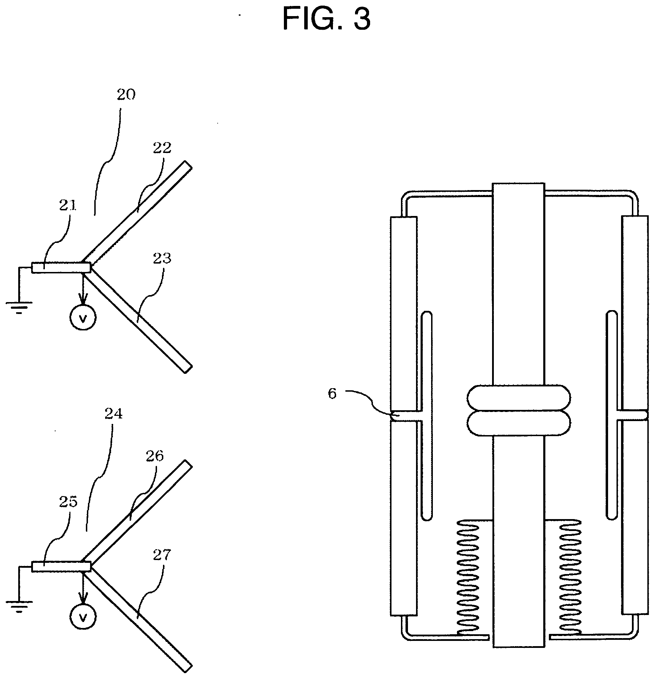

FIG. 3 shows Embodiment 3 of the present invention. Description on portions similar to those of Embodiment 1 and Embodiment 3 will be omitted. In the pressure diagnostic device of the present embodiment, the pressure diagnostic device formed of the insulator group and the potential measuring instrument of Embodiment 2 is arranged by plural sets. Here, for the purpose of simple explanation, description is made with respect to the case in which 2 sets of a pressure diagnostic device 20 and a pressure diagnostic device 24 are arranged, however, the present invention is not to be limited to the case of 2 sets. In the present embodiment also, the insulator on the side close to the floating potential metal 6 is arranged by plural numbers. Respective insulators which are close to the floating potential metal 6 have different impedance.

In the present embodiment, pressure diagnosis of the vacuum valve is executed by changing the distance between the floating potential metal 6 of the vacuum valve and any of an insulator 22, an insulator 23, an insulator 26, and an insulator 27 on the side closest to the floating potential metal 6 at the normal operation time of the vacuum valve. In the vacuum valve pressure diagnostic device configured thus, the drop width of the potential of the floating potential metal can be changed still more greatly or still more finely compared to Embodiment 2. As a result, because the electric discharge can be detected with still higher sensitivity compared to Embodiment 2, the vacuum valve pressure diagnostic device having still higher reliability can be provided.

### EMBODIMENT 4

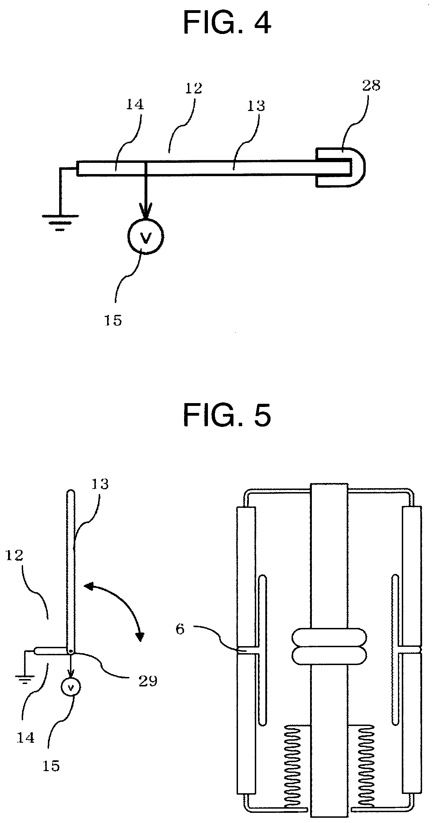

FIG 4 shows Embodiment 4 of the present invention, and shows a side view of the pressure diagnostic device 12. Description on portions similar to those of Embodiment 1 will be omitted. The pressure diagnostic device 12 in the present embodiment has a construction that the distal end of the insulator 13 located on the side close to the floating potential metal 6 (the distal end on the side close to the floating potential metal 6) is covered with an insulator 28 having a relative dielectric constant lower than the relative dielectric constant of the insulator 13.

In the present embodiment configured thus, the electric field between the floating potential metal 6 and the insulator 13 at the pressure diagnosis time can be relaxed. In particular, when the floating potential metal 6 and the insulator 28 contact each other, the electric field of the contact part namely the triple point which is formed of the metal, insulator and gas and is feared to be a weak point of insulation can be relaxed. As a result, because the length of the insulator 13 located on the side close to the floating potential metal 6 of the pressure diagnostic device 12 can be shortened, a compact pressure diagnostic device can be provided.

Also, the insulator covering the distal end of the insulator located on the side close to the floating potential metal is not required to cover at all times, and only has to cover the distal end of the insulator located on the side close to the floating potential metal at the pressure diagnosis time (particularly at the time of contact). In concrete terms, it only has to cover the distal end at least when it comes close to the floating potential metal. It is a matter of course that it may be configured to cover the distal end at all times.

### EMBODIMENT 5

FIG. 5 shows Embodiment 5 of the present invention. Description on portions similar to those of Embodiment 1 will be omitted. Description is made with respect to a case the pressure diagnostic device 12 in the present embodiment includes a rotation drive mechanism as a means for enabling to change the distance of the insulator 13 located on the side close to the floating potential metal 6 with respect to the floating potential metal 6 at the pressure diagnosis time. In concrete terms, with respect to the insulator 13 located on the side close to the floating potential metal 6, a rotation center 29 is arranged on the side of the end on the side far from the floating potential metal 6 for supporting, the insulator 13 is rotated by effecting an arc motion around the rotation center 29, and thereby the distance with respect to the floating potential metal 6 is changed.

In the vacuum valve pressure diagnostic device configured thus, when the insulator 13 rotates and approaches the floating potential metal 6, the space capacitance between the insulator 13 and the floating potential metal 6 increases which means that the impedance reduces. In other words, the drop width of the potential of the floating potential metal 6 can be changed by the rotation angle of the insulator 13. As a result, because electric discharge inside the vacuum valve can be detected with high sensitivity, a vacuum valve pressure diagnostic device having high reliability can be provided.

### EMBODIMENT 6

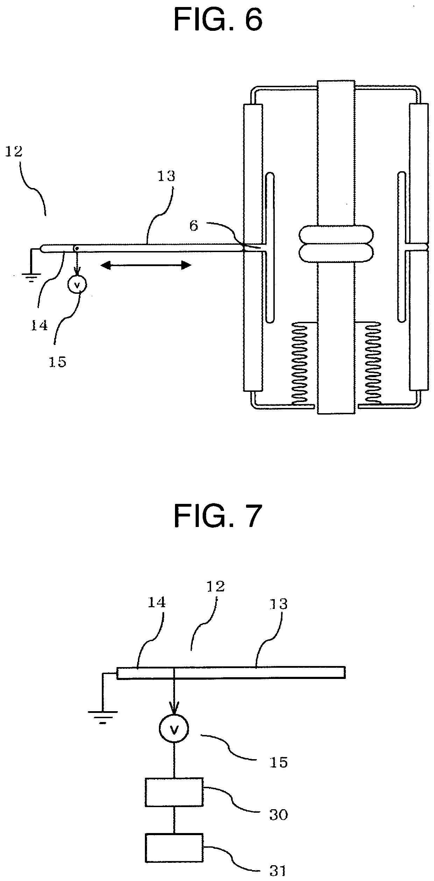

FIG. 6 shows Embodiment 6 of the present invention. Description on portions similar to those of Embodiment 1 will be omitted. Description is made with respect to a case the pressure diagnostic device 12 in the present embodiment includes a linear drive mechanism as a means for enabling to change the distance of the insulator 13 located on the side close to the floating potential metal 6 with respect to the floating potential metal 6 at the pressure diagnosis time. In concrete terms, the distance with respect to the floating potential metal 6 is changed by moving the insulator 13 located on the side close to the floating potential metal 6 on a straight line. That moving on a straight line may be not only the insulator 13 but also the entire pressure diagnostic device.

The vacuum valve pressure diagnostic device configured thus can secure the effects similar to those of Embodiment 5, and can provide a vacuum valve pressure diagnostic device having high reliability.

### EMBODIMENT 7

FIG. 7 shows Embodiment 7 of the present invention. Description on portions similar to those of Embodiment 1 will be omitted. In the pressure diagnostic device of the present invention, a pressure abnormality determination device 30 is connected to the potential measuring instrument 15. Also, this pressure abnormality determination device 30 is configured to be capable of wire or wireless information communication with a controller 31 of a switchgear mounted with the vacuum valve. When the pressure abnormality determination device 30 detects pressure abnormality, an open motion disable command disabling the open motion of the vacuum valve or a pressure abnormality alarm command alarming the pressure abnormality is outputted to the controller 31 of the switchgear. Also, the means for communication with the vacuum valve does not have to be included in the pressure abnormality determination device itself, and it is also possible that another means is configured to effect communication based on the determination result by the pressure abnormality determination device.

In the present embodiment configured thus, the vacuum valve pressure diagnostic device capable of preventing a ground fault accident and having improved safety and reliability can be provided.

When open motion is effected while the pressure abnormality occurs in the vacuum valve, because there is a problem that electric discharge occurs between the electrodes and the ground fault accident is caused, when the pressure abnormality of the vacuum valve is detected, the open motion disable command disabling the open motion of the vacuum valve or the pressure abnormality alarm command alarming the pressure abnormality is outputted, and thereby the vacuum valve pressure diagnostic device capable of preventing a ground fault accident and having improved safety and reliability can be provided.

### EMBODIMENT 8

FIG. 8 shows Embodiment 8 of the present invention. Description on portions similar to those of Embodiment 1 will be omitted. There is a case an insulation member 32 (insulation case) made of a resin raw material such as epoxy or a grounding member 32 having the ground potential is disposed around the vacuum valve. These respective members 32 and the vacuum valve are disposed at a distance capable of securing predetermined insulation performance which is determined by the operation voltage. In the pressure diagnostic device in the present invention, the insulator group and the vacuum valve are disposed so that the distance therebetween becomes greater than the distance from the insulator group to the grounding portion or the insulation case at the time other than the pressure diagnosis time.

In the present embodiment configured thus, the vacuum valve pressure diagnostic device capable of maintaining the insulation performance of the vacuum valve at the normal operation time stable can be provided.

Even when the pressure diagnostic device (disposed at a position far with respect to the vacuum valve from the insulation member or the grounding member disposed around the vacuum valve) moves and the distance between the pressure diagnostic device and the vacuum valve changes more or less, because the potential of the floating potential metal 6 of the vacuum valve is determined by the vacuum valve surrounding member, variation of the potential can be suppressed.

### REFERENCE SIGNS LIST

1: vacuum valve,
2: fixed side cylindrical insulation tube,
3: fixed side end plate,
4: fixed side conductor,
5: movable side cylindrical insulation tube,
6: floating potential metal,
7: movable side end plate,
8: bellows,
9: movable side conductor,
10: fixed side electrode,
11: movable side electrode,
12, 16, 20, 24: pressure diagnostic device,
13, 14, 17, 18, 19, 21, 22, 23, 25, 26, 27: insulator,
15: potential measuring instrument,
28: insulator,
29: rotation center,
30: pressure abnormality determination device,
31: controller for switchgear,
32: insulation member or grounding member

## Claims

1. A vacuum valve pressure diagnostic device (12, 16, 20, 24) diagnosing the pressure of a vacuum valve (1) that has therein a vacuum container whose interior is a vacuum, a plurality of contact points that are disposed inside the vacuum container and can be brought into mutual contact or separated from each other, and a floating potential metal (6) electrically insulated from the contact points, comprising:
an insulator group constituted by connecting at least some of a plurality of insulators (13, 14, 17, 18, 19, 21, 22, 23, 25, 26, 27) in series; and
a potential measuring instrument (15) connected between the plurality of insulators (13, 14, 17, 18, 19, 21, 22, 23, 25, 26, 27), wherein
for at least one insulator (13, 18, 19, 22, 23, 26, 27) located on the side close to the floating potential metal (6) within the insulator group, the distance to the floating potential metal (6) is changed so as to become short at the time of pressure diagnosis; and
the insulator (14, 17, 21, 25) which is different from the at least one insulator (13, 18, 19, 22, 23, 26, 27) located on the side close to the floating potential metal (6) within the insulator group is connected to a potential fixed point at the time of pressure diagnosis.

2. The vacuum valve pressure diagnostic device (12, 16, 20, 24) according to Claim 1, wherein
impedance of the insulator (13) on the side close to the floating potential metal (6) than the potential measuring instrument (15) is greater than impedance of the insulator (14) on the side far from the floating potential metal (6) than the potential measuring instrument (15).

3. The vacuum valve pressure diagnostic device (16) according to Claim 2, wherein
the insulator (18, 19) located on the side close to the floating potential metal (6) within the insulator group is arranged by a plurality.

4. The vacuum valve pressure diagnostic device (20, 24) according to Claim 3, wherein
the insulator group (21, 25) and the potential measuring instrument (15) connected to the insulator group (21, 25) are arranged by a plurality.

5. The vacuum valve pressure diagnostic device (16, 20, 24) according to Claims 3 or 4, wherein
any of the insulators (18, 19, 22, 23, 26, 27) located on the side close to the plurality of the floating potential metal (6) are connected to the insulator (17, 21, 25) different from at least one of the insulators (18, 19, 22, 23, 26, 27) located on the side close to the plurality of the floating potential metal (6) within the insulator group.

6. The vacuum valve pressure diagnostic device (16, 20, 24) according to any one of Claims 3 to 5, wherein
the insulators (18, 19, 22, 23, 26, 27) located on the side close to the plurality of the floating potential metal (6) have impedance different from each other.

7. The vacuum valve pressure diagnostic device (12, 16, 20, 24) according to any one of Claims 1 to 6, wherein
the distal end of the insulator (13) located on the side close to the floating potential metal (6) is covered with an insulator (28) having the relative dielectric constant lower than the relative dielectric constant of the insulator (13) at least when the insulator (13) is brought close to the floating potential metal (6).

8. The vacuum valve pressure diagnostic device (12, 16, 20, 24) according to Claim 7, wherein
the distal end of the insulator (13) located on the side close to the floating potential metal (6) is covered at all times with an insulator (28) having the relative dielectric constant lower than the relative dielectric constant of the insulator (13).

9. The vacuum valve pressure diagnostic device (12, 16, 20, 24) according to any one of Claims 1 to 8, further comprising:
a rotation drive mechanism rotating the at least one insulator (13) located on the side close to the floating potential metal (6) at the time of pressure diagnosis.

10. The vacuum valve pressure diagnostic device (12, 16, 20, 24) according to any one of Claims 1 to 8, wherein
the at least one insulator (13) located on the side close to the floating potential metal (6) is moved on a straight line at the time of pressure diagnosis.

11. The vacuum valve pressure diagnostic device (12, 16, 20, 24) according to any one of Claims 1 to 10, wherein
when pressure abnormality is detected, an open motion disable command disabling an open motion of the vacuum valve (1) or a pressure abnormality alarm command alarming the pressure abnormality is outputted.

12. A vacuum valve device having a pressure diagnosis function, comprising:
the vacuum valve pressure diagnostic device (12, 16, 20, 24) according to any one of Claims 1 to 11; and
the vacuum valve (1).

13. The vacuum valve device according to Claim 12, further comprising:
an insulation case (32) that is formed of an insulator or a grounding portion (32) that becomes ground potential, wherein,
the insulator group (13, 14, 17, 18, 19, 21, 22, 23, 25, 26, 27) and the vacuum valve (1) are disposed so that the distance therebetween becomes greater than the distance from the insulator group (13, 14, 17, 18, 19, 21, 22, 23, 25, 26, 27) to the grounding portion (32) or the insulation case (32) at the time other than the pressure diagnosis time.
